# EUROPEAN PATENT SPECIFICATION

(11) **EP 3 950 226 B1**
(45) Date of publication and mention of the grant of the patent: **18.12.2024**
(21) Application number: 20781959.0
(22) Date of filing: 18.03.2020
(51) Int. Cl.: B24B 27/06, C09J 7/29, H01L 21/301, H01L 21/00

(54) **METHOD FOR PRODUCING ELECTRONIC DEVICE**
VERFAHREN ZUR HERSTELLUNG EINER ELEKTRONISCHEN VORRICHTUNG
PROCÉDÉ DE PRODUCTION DE DISPOSITIFS ÉLECTRONIQUES

(30) Priority: 29.03.2019 JP 2019067115
(43) Date of publication of application: 09.02.2022
(73) Proprietor: Mitsui Chemicals ICT Materia, Inc., Chuo-ku, Tokyo (JP)
(72) Inventor: HAYASHISHITA Eiji, Nagoya-shi, Aichi 457-0801 (JP)
(74) Representative: Hoffmann Eitle
(86) International application number: PCT/JP2020/011930
(87) International publication number: WO 2020/203287

(56) References cited:
- EP-A1- 1 865 545
- JP-A- 2006 049 507
- JP-A- 2006 049 509
- JP-A- 2006 049 509
- JP-A- 2011 018 669
- JP-A- 2012 036 374
- JP-A- 2012 119 395
- JP-A- 2015 162 561
- JP-A- 2015 162 561

## Description

### TECHNICAL FIELD

The present invention relates to a method for manufacturing an electronic device.

### BACKGROUND ART

In electronic device manufacturing steps, there is a step of dicing electronic components, such as semiconductor substrates, into a plurality of electronic components.

In this dicing step, for example, electronic components are diced to obtain a plurality of electronic components in a state where the electronic components are attached on an adhesive film.

Techniques related to adhesive films used in such a dicing step include, for example, the techniques described in Patent Document 1 (Japanese Unexamined Patent Application, Publication No. 2019-16634) .

Patent Document 1 describes a dicing tape which has a laminated structure including a base material and an adhesive layer, in which a value of a ratio of a second tensile stress, which is generated at a strain value of 20% in a tensile test performed under the conditions of an initial chuck distance of 100 mm, 23°C, and a tensile speed of 1000 mm/min for a dicing tape specimen having a width of 20 mm, with respect to a first tensile stress, which is generated at a strain value of 20% in a tensile test performed under the conditions of an initial chuck distance of 100 mm, 23°C, and a tensile speed of 10 mm/min for a dicing tape specimen having a width of 20 mm, is 1.4 or more.

From EP 1 865 545 A1 there is known a method for manufacturing an electronic device, the method comprising: a step of preparing a structure provided with an electronic component and an adhesive film attached to the electronic component and a step of dicing the electronic component with a dicing blade in a state of being attached to the adhesive film, wherein the adhesive film is provided with a base material layer, an intermediate layer, and an adhesive resin layer in this order and wherein a tip of the dicing blade has a tapered shape.

### RELATED DOCUMENT

### PATENT DOCUMENT

[Patent Document 1] Japanese Unexamined Patent Application, Publication No. 2019-16634

### SUMMARY OF THE INVENTION

### TECHNICAL PROBLEM

According to research by the present inventors, the following problems were found in relation to the methods for manufacturing electronic devices in the related art.

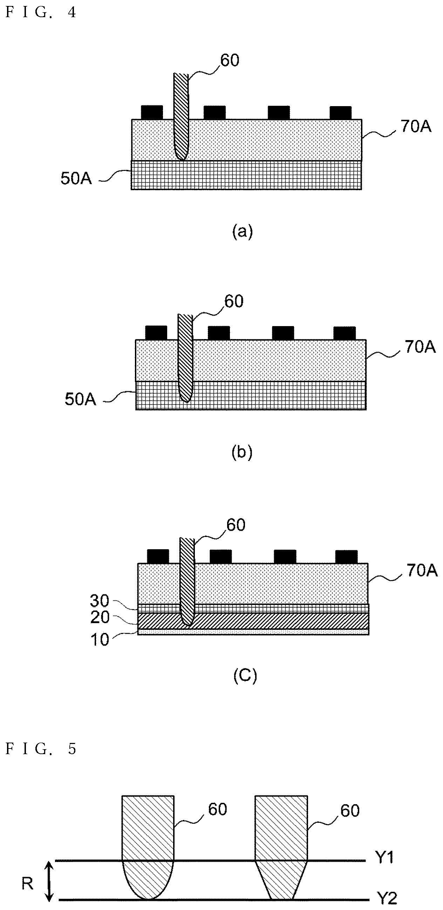

First, the tip of the dicing blade used in the dicing step is usually not flat, but has a tapered shape such as a semicircle, semi-ellipse, or V-shape. Therefore, as shown in Fig. 4(a), in a step of dicing an electronic component 70A into a plurality of electronic components 70A using such a dicing blade 60, in a case where the tip of the dicing blade 60 cuts into the interface between the electronic component 70A and an adhesive film 50A, the side surfaces of the diced electronic component 70A may not form a linear shape.

Therefore, as shown in Fig. 4(b), it was necessary for the tip of the dicing blade 60 to cut into the adhesive film 50A. In this manner, it is possible to obtain the electronic component 70A having side surfaces with a good linear shape.

However, in order for the tip of the dicing blade to cut into the adhesive film, it was necessary to increase the thickness of the adhesive film. It was clear that, when the thickness of the adhesive film was increased, the flexibility of the adhesive film decreased and, as a result, it became difficult to deform the film to which the electronic component was attached and it was no longer possible to successfully pick up the diced electronic components.

That is, the present inventors found that there is room for improvement in the methods for manufacturing an electronic device of the related art from the viewpoints of both obtaining electronic components having side surfaces with a good linear shape and achieving the pick-up characteristic of the diced electronic components.

The present invention was made in consideration of the circumstances described above and provides a method for manufacturing an electronic device capable of obtaining electronic components having side surfaces with a good linear shape and with which it is possible to pick up diced electronic components with good precision.

### SOLUTION TO PROBLEM

The present inventors carried out intensive research in order to achieve the object described above. As a result, the inventors found that by using an adhesive film provided with a base material layer, an intermediate layer, and an adhesive resin layer in this order and furthermore, in which the thickness of the intermediate layer is thicker than the thickness of the base material layer, it is possible to both obtain electronic components having side surfaces with a good linear shape and achieve the pick-up characteristic of the diced electronic components, thereby completing the present invention.

According to the present invention, a method for manufacturing an electronic device as defined in claim 1 is provided.

Further embodiments are defined in the dependent claims.

### ADVANTAGEOUS EFFECTS OF INVENTION

According to the present invention, it is possible to provide a method for manufacturing an electronic device capable of obtaining electronic components having side surfaces with a good linear shape and with which it is possible to pick up diced electronic components with good precision.

### BRIEF DESCRIPTION OF THE DRAWINGS

Fig. 1 is a cross-sectional view schematically showing an example of a structure of an adhesive film of an embodiment according to the present invention.
Fig. 2 is a cross-sectional view schematically showing an example of a method for manufacturing an electronic device of an embodiment according to the present invention.
Fig. 3 is a cross-sectional view schematically showing an example of a method for manufacturing an electronic device of an embodiment according to the present invention.
Fig. 4 is a cross-sectional view schematically showing an example of a state in which an electronic component is cut into using a dicing blade.
Fig. 5 is a cross-sectional view schematically showing an example of a tip diameter R of a dicing blade.

### DESCRIPTION OF EMBODIMENTS

A description will be given below of embodiments of the present invention with reference to the drawings. In all the drawings, common reference numerals are given to the same constituent components and description thereof will not be provided as appropriate. In addition, the figures are schematic views and do not match the actual dimensional ratios. In addition, unless otherwise specified, "A to B" in the numerical range represents A or more and B or less. In addition, in the present embodiment, "(meth)acrylic" means acrylic, methacrylic, or both acrylic and methacrylic.

### 1. Adhesive Film

A description will be given below of the adhesive film 50 according to the present embodiment.

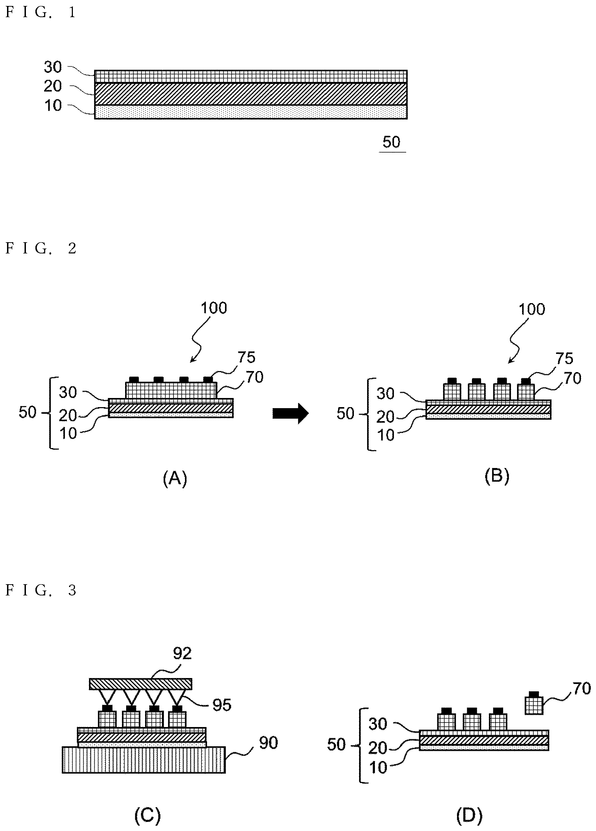

Fig. 1 is a cross-sectional view schematically showing an example of the structure of the adhesive film 50 of the embodiment according to the present invention.

As shown in Fig. 1, the adhesive film 50 according to the present embodiment is an adhesive film used to temporarily fix electronic components in an electronic component dicing step and is provided with a base material layer 10, an intermediate layer 20, and an adhesive resin layer 30 in this order.

In the adhesive film 50 according to the present embodiment, when the thickness of the base material layer 10 is X₁ and the thickness of the intermediate layer 20 is X₂, the relationship X₂ > X₁ is satisfied.

The present inventors carried out intensive research in order to realize an adhesive film with which it is possible to both obtain electronic components having side surfaces with a good linear shape and achieve the pick-up characteristic of the diced electronic components.

As a result, by providing the intermediate layer 20 between the base material layer 10 and the adhesive resin layer 30 and making the thickness of the intermediate layer 20 thicker than the thickness of the base material layer 10, it is possible to increase the overall thickness of the adhesive film 50 even without increasing the thickness of the base material layer 10, which is inferior in elasticity and flexibility, and, as a result, as shown in Fig. 4(c), the tip of the dicing blade is able to sufficiently cut thereinto and it is possible to improve the flexibility of the adhesive film 50 on the adhesive resin layer 30 side to which the electronic components are fixed. That is, the present inventors found for the first time that providing the intermediate layer 20 between the base material layer 10 and the adhesive resin layer 30 and making the thickness of the intermediate layer 20 thicker than the thickness of the base material layer 10 makes it possible to both obtain electronic components having good side surfaces with a linear shape and achieve the pick-up characteristic of the diced electronic components.

Thus, according to the adhesive film 50 according to the present embodiment, it is possible to obtain the electronic component 70 having side surfaces with a good linear shape and to pick-up the diced electronic component 70 with good precision.

The thickness of the entire adhesive film 50 according to the present embodiment is preferably 25 um or more and 500 pm or less, more preferably 30 um or more and 400 um or less, and even more preferably 30 um or more and 300 pm or less, in terms of the balance of mechanical characteristics and handling properties.

It is possible to use the adhesive film 50 according to the present embodiment to temporarily fix the electronic component described above when dicing the electronic component in an electronic device manufacturing step. That is, it is possible to suitably use the adhesive film 50 according to the present embodiment as a dicing tape in an electronic component dicing step.

The total light transmittance of the adhesive film 50 according to the present embodiment is preferably 80% or more, and more preferably 85% or more. In this manner, it is possible to impart transparency to the adhesive film 50. By setting the total light transmittance of the adhesive film 50 to the lower limit value described above or more, it is possible to irradiate the adhesive resin layer 30 with radiation more effectively and to improve the radiation irradiation efficiency. It is possible to measure the total light transmittance of the adhesive film 50 in accordance with JIS K7105 (1981).

Next, a description will be given of each layer forming the adhesive film 50 according to the present embodiment.

### <Base Material Layer>

The base material layer 10 is a layer provided for the purpose of making the handling property and characteristics, such as the mechanical characteristics and heat resistance, of the pressure sensitive adhesive film 50 more favorable. Here, in the present embodiment, heat resistance means the dimensional stability of the film or resin layer at high temperatures or low temperatures. That is, the better the heat resistance of the film or resin layer is, the less likely it is for deformation such as expansion, contraction, or softening, melting, or the like to occur at high temperatures or low temperatures.

The base material layer 10 is not particularly limited as long as there is sufficient mechanical strength to withstand external forces applied thereto when dicing electronic components and examples thereof include a resin film.

In addition, the base material layer 10 is preferably heat-resistant such that, when performing characteristic evaluation of the electronic components 70 at high temperatures or low temperatures, deformation or melting to the extent that the positions of the electronic components 70 are shifted does not occur.

From the viewpoint of excellent heat resistance, examples of resins forming the resin film described above include one or two or more selected from polyesters such as polyethylene terephthalate, polybutylene terephthalate, polyethylene naphthalate, and polybutylene naphthalate; polyamides such as nylon-6, nylon-66, and polymetaxylene adipamide; polyimide; polyetherimide; polyamide-imide; polycarbonate; modified polyphenylene ether; polyacetal; polyarylate; polysulfone; polyethersulfone; polyphenylene sulfide; polyetheretherketone; fluorine-based resins; liquid crystal polymers; vinylidene chloride resins; polybenzimidazole; polybenzoxazole; polymethylpentene, and the like.

Among these, from the viewpoint of excellent balance of heat resistance, mechanical strength, transparency, price, and the like, one or two or more selected from polyimides, polyamides, and polyesters are preferable, at least one type selected from polyethylene terephthalate and polyethylene naphthalate is more preferable, and polyethylene naphthalate is even more preferable.

The melting point of the base material layer 10 is preferably 200°C or higher, and more preferably 220°C or higher. Alternatively, it is preferable that the base material layer 10 does not exhibit a melting point, it is more preferable that the decomposition temperature is 200°C or higher, and it is even more preferable that the decomposition temperature is 220°C or higher.

When such the base material layer 10 is used, it is possible to further suppress the deformation of the adhesive film 50 when evaluating the characteristics of the electronic component 70 at high temperatures or low temperatures.

The base material layer 10 may be a single layer or two or more types of layer.

In addition, the form of the resin film used to form the base material layer 10 may be a stretched film, or may be a film which is stretched in a uniaxial or biaxial direction.

In the adhesive film 50 of the present embodiment, from the viewpoint of making the handling property and characteristics, such as the mechanical characteristics and heat resistance, of the adhesive film 50 more favorable, the storage modulus E' of the base material layer 10 at 85°C is preferably 50 MPa or more, more preferably 100 MPa or more, and even more preferably 200 MPa or more, and preferably 10 GPa or less, and more preferably 5 GPa or less.

It is possible to control the storage modulus E' of the base material layer 10 at 85°C in the range described above by, for example, controlling the type and blending ratio of each component forming the base material layer 10.

From the viewpoint of making the handling property and characteristics, such as the mechanical characteristics and heat resistance, of the adhesive film 50 more favorable, the thickness (X₁) of the base material layer 10 is preferably 1 pm or more, more preferably 2 pm or more, even more preferably 3 pm or more, yet more preferably 5 pm or more, and particularly preferably 10 m or more.

In addition, from the viewpoint of making the in-plane directional expandability of the adhesive film 50 more favorable, the thickness (X₁) of the base material layer 10 is preferably 100 um or less, more preferably 75 um or less, even more preferably 50 um or less, yet more preferably 40 um or less, and particularly preferably 30 um or less.

The base material layer 10 may be subj ected to a surface treatment in order to improve the adhesiveness with other layers. Specifically, a corona treatment, a plasma treatment, an undercoat treatment, a primer coat treatment, and the like may be performed.

### <Intermediate Layer>

The intermediate layer 20 is a layer provided to adjust the thickness of the adhesive film 50 to a range which makes it possible for the tip of a dicing blade to cut thereinto while favorably maintaining the flexibility of the adhesive film 50 on the adhesive resin layer 30 side.

That is, providing the intermediate layer 20 makes it possible to both obtain electronic components having side surfaces with a good linear shape and achieve the pick-up characteristic of the diced electronic components.

The resin forming the intermediate layer 20 is not particularly limited as long as it is possible to favorably maintain the flexibility of the adhesive film 50 on the adhesive resin layer 30 side even when the thickness of the intermediate layer 20 is increased; however, for example, a thermoplastic resin is preferable.

The thermoplastic resin according to the present embodiment is not particularly limited as long as the resin is able to form the intermediate layer 20; however, for example, it is possible to use one or two or more selected from an olefin-based resins such as ethylene-α-olefin copolymer including ethylene and an α-olefin having 3 to 20 carbon atoms, high-density ethylene-based resins, low-density ethylene-based resins, medium-density ethylene-based resins, ultra-low density ethylene-based resins, linear low-density polyethylene (LLDPE) based resins, propylene (co)polymers, 1-butene (co)polymers, 4-methylpentene-1 (co)polymers, ethylene cyclic olefin copolymers, ethylene α-olefin cyclic olefin copolymers, ethylene α-olefin non-conjugated polyene copolymers, ethylene α-olefin conjugated polyene copolymers, ethylene aromatic vinyl copolymers, and ethylene α-olefin aromatic vinyl copolymers; ethylene (meth)acrylic acid ester copolymers such as ethylene (meth)acrylic acid ethyl copolymers, ethylene (meth)acrylic acid methyl copolymers, ethylene (meth)acrylic acid propyl copolymers, ethylene (meth) acrylic acid butyl copolymers, ethylene (meth) acrylic acid hexyl copolymers, ethylene (meth)acrylic acid 2-hydroxyethyl copolymers, ethylene (meth) acrylic acid 2-hydroxypropyl copolymers, and ethylene (meth)acrylic acid glycidyl copolymers; ethylene vinyl ester copolymers such as ethylene vinyl acetate copolymers, ethylene vinyl propionate copolymers, ethylene vinyl butyrate copolymers, and ethylene vinyl stearate copolymers; polyvinyl chloride; polyvinylidene chloride; polyolefin-based thermoplastic elastomers; polystyrene-based thermoplastic elastomers; polyurethane-based thermoplastic elastomers; 1,2-polybutadiene-based thermoplastic elastomers; trans-polyisoprene-based thermoplastic elastomers; chlorinated polyethylene-based thermoplastic elastomers; polyester-based elastomers, and the like.

Among these, at least one type selected from an ethylene-α-olefin copolymer and an ethylene vinyl ester copolymer is preferable, at least one type selected from an ethylene-α-olefin copolymer and an ethylene vinyl acetate copolymer is more preferable, and an ethylene vinyl acetate copolymer is even more preferable. In the present embodiment, the resins described above may be used alone or used in a blend.

The content of vinyl acetate units in the ethylene vinyl acetate copolymer is preferably 10% by mass or more and 35% by mass or less, more preferably 12% by mass or more and 30% by mass or less, and even more preferably 15% by mass or more and 25% by mass or less. When the content of vinyl acetate units is in this range, the balance of cross-linkability, flexibility, weather resistance, and transparency is superior.

It is possible to measure the vinyl acetate content in accordance with JIS K6730.

As the α-olefin of the ethylene-α-olefin copolymer formed of ethylene and an α-olefin having 3 to 20 carbon atoms, which is used as the thermoplastic resin in the present embodiment, usually, it is possible to use one type alone or a combination of two or more types of α-olefins having 3 to 20 carbon atoms. Among these, α-olefins having 10 or less carbon atoms are preferable and α-olefins having 3 to 8 carbon atoms are particularly preferable. Examples of such α-olefins include propylene, 1-butene, 1-pentene, 1-hexene, 3-methyl-1-butene, 3,3-dimethyl-1-butene, 4-methyl-1-pentene, 1-octene, 1-decene, 1-dodecene, and the like. Among these, propylene, 1-butene, 1-pentene, 1-hexene, 4-methyl-1-pentene, and 1-octene are preferable for ease of availability. The ethylene-α-olefin copolymer may be a random copolymer or a block copolymer, but a random copolymer is preferable from the viewpoint of flexibility.

The thickness (X₂) of the intermediate layer 20 is not particularly limited, as long as it is possible to adjust the thickness of the adhesive film 50 to a range in which it is possible for the tip of the dicing blade to sufficiently cut thereinto, but, for example, 10 um or more is preferable, 20 um or more is more preferable, 30 um or more is even more preferable, 50 um or more is yet more preferable, and 60 um or more is particularly preferable.

In addition, from the viewpoint of making the flexibility of the adhesive film 50 on the adhesive resin layer 30 side more favorable, the thickness (X₂) of the intermediate layer 20 is preferably 500 um or less, more preferably 400 um or less, even more preferably 300 um or less, yet more preferably 200 um or less, still more preferably 150 um or less, and particularly preferably 130 um or less.

Here, when the tip diameter of the dicing blade is R, the relationship X₂ > R is preferably satisfied. In this manner, it is possible for the tip of the dicing blade to sufficiently cut into the adhesive film 50, and, as a result, it is possible to give the side surface of the electronic component after dicing a more favorable linear shape. In the present embodiment, the tip diameter R of the dicing blade refers to the distance from a portion Y1 where the side surface of the dicing blade is no longer linear to a tip Y2 of the dicing blade, as shown in Fig. 5.

In the adhesive film 50 according to the present embodiment, from the viewpoint of making the handling property and characteristics, such as the mechanical characteristics and heat resistance, of the adhesive film 50 more favorable, the storage modulus E' of the intermediate layer 20 at 85°C is preferably 1 MPa or more, and more preferably 10 MPa or more, and, from the viewpoint of making the flexibility of the adhesive film 50 on the adhesive resin layer 30 side more favorable, preferably less than 50 MPa.

It is possible to control the storage modulus E' of the intermediate layer 20 at 85°C in the ranges described above by, for example, controlling the type and blending ratio of each component forming the intermediate layer 20.

The intermediate layer 20 may be capable of cross-linking from the viewpoint of improving the heat resistance of the adhesive film 50.

The cross-linking method of the intermediate layer 20 is not particularly limited as long as the method is able to cross-link the resin forming the intermediate layer 20 and examples thereof include cross-linking methods such as cross-linking by a radical polymerization initiator; cross-linking by sulfur or a sulfur-based compound; and cross-linking by radiation such as ultraviolet rays, electron beams, and γ rays.

Among these, cross-linking by electron beams is preferable.

For cross-linking by a radical polymerization initiator, it is possible to use the radical polymerization initiator used for cross-linking of the resin forming the intermediate layer 20. As the radical polymerization initiator, it is possible to use a known thermal radical polymerization initiator, a photo-radical polymerization initiator, and combinations thereof.

In a case of cross-linking the intermediate layer 20 using sulfur or a sulfur-based compound, the intermediate layer 20 may be cross-linked by blending with a vulcanization accelerator, a vulcanization accelerator aid, or the like.

In addition, in any of the cross-linking methods, a cross-linking aid may be blended with the intermediate layer 20 to cross-link the intermediate layer 20.

### < Adhesive Resin Layer>

The adhesive resin layer 30 is a layer which contacts and adheres to the surface of the electronic component 70 when the adhesive film 50 is attached to the electronic component 70.

Examples of adhesives forming the adhesive resin layer 30 include (meth)acrylic-based adhesives, silicone-based adhesives, urethane-based adhesives, olefin-based adhesives, styrene-based adhesives, and the like. Among the above, from the point of view that it is possible to easily adjust the adhesive strength or the like, a (meth)acrylic-based adhesive having a (meth)acrylic-based polymer as a base polymer is preferable.

As the adhesive forming the adhesive resin layer 30, it is possible to use a radiation cross-linking adhesive which decreases the adhesive strength by radiation. Since the adhesive resin layer 30 formed by the radiation cross-linking adhesive is cross-linked by irradiation with radiation and the adhesive strength is significantly reduced, it is easier to pick up the electronic component 70 from the adhesive resin layer 30 in the step of picking up the electronic component 70. Examples of the radiation includes ultraviolet rays, electron beams, infrared rays, and the like.

As a radiation cross-linking adhesive, an ultraviolet cross-linking adhesive is preferable.

Examples of the (meth)acrylic-based polymer included in the (meth)acrylic-based adhesive include a monopolymer of a (meth)acrylic acid ester compound, a copolymer of a (meth)acrylic acid ester compound and a comonomer, and the like.

Examples of (meth) acrylic acid ester compounds include methyl (meth)acrylate, ethyl (meth)acrylate, butyl (meth)acrylate, 2-ethylhexyl (meth)acrylate, hydroxyethyl (meth)acrylate, hydroxypropyl (meth)acrylate, dimethylaminoethyl (meth)acrylate, glycidyl (meth)acrylate, and the like. These (meth)acrylic acid ester compounds may be used alone as one type or two or more may be used in combination.

In addition, examples of comonomers forming (meth) acrylic-based copolymers include vinyl acetate, (meth)acrylonitrile, (meth)acrylic amide, styrene, (meth)acrylic acid, itaconic acid, (meth) acrylic amide, methylol (meth) acrylic amide, maleic anhydride, and the like. One type of these comonomers may be used alone, or two or more may be used in combination.

A radiation cross-linking adhesive includes, for example, an adhesive such as the (meth)acrylic-based adhesive described above, a cross-linking compound (a component having carbon-carbon double bonds), and a photopolymerization initiator or a thermal polymerization initiator.

Examples of the cross-linking compound include monomers, oligomers, polymers, or the like which have carbon-carbon double bonds in the molecule and are able to be cross-linked by radical polymerization. Examples of such cross-linking compounds include esters of (meth)acrylic acid with polyhydric alcohols such as trimethylolpropane tri(meth)acrylate, pentaerythritol tri(meth)acrylate, tetraethylene glycol di(meth)acrylate, 1,6-hexanediol di (meth) acrylate, neopentyl glycol di (meth) acrylate, and dipentaerythritol hexa(meth)acrylate; ester (meth)acrylate oligomers; isocyanurates or isocyanurate compounds such as 2-propenyl di-3-butenyl cyanurate, 2-hydroxyethyl bis(2-(meth)acryloxyethyl)isocyanurate, and tris(2-methacryloxyethyl)isocyanurate, and the like.

In a case where the adhesive is a radiation-cross-linked polymer having carbon-carbon double bonds in the side chain of the polymer, a cross-linking compound may not be added.

The content of the cross-linking compound is preferably 5 to 100 parts by mass with respect to 100 parts by mass of adhesive, and more preferably 10 to 50 parts by mass.

Due to the content of the cross-linking compound being in the range described above, it is easier to adjust the adhesive strength in comparison with a case where the content is less than the range described above, and a decrease in storage stability is less likely to occur due to excessive sensitivity with respect to heat or light in comparison with a case where the content is greater than the range described above.

The photopolymerization initiator may be any compound which cleaves and generates radicals upon being irradiated with radiation and examples thereof include benzoin alkyl ethers such as benzoin methyl ether, benzoin isopropyl ether, and benzoin isobutyl ether; aromatic ketones such as benzyl, benzoin, benzophenone, and α-hydroxycyclohexylphenyl ketone; aromatic ketals such as benzyl dimethyl ketal; polyvinyl benzophenone; thioxanthones such as chlorothioxanthone, dodecyl thioxanthone, dimethyl thioxanthone, and diethyl thioxanthone, and the like.

Examples of thermal polymerization initiators include organic peroxide derivatives, azo-based polymerization initiators, and the like. From the point of view that nitrogen is not generated during heating, an organic peroxide derivative is preferable. Examples of thermal polymerization initiators include ketone peroxides, peroxyketals, hydroperoxides, dialkyl peroxides, diacyl peroxides, peroxyesters, peroxydicarbonates, and the like.

A cross-linking agent may be added to the adhesive. Examples of cross-linking agents include epoxy-based compounds such as sorbitol polyglycidyl ether, polyglycerol polyglycidyl ether, pentaerythritol polyglycidyl ether, and diglycerol polyglycidyl ether; aziridine-based compounds such as tetramethylolmethane-tri-β-aziridinyl propionate, trimethylolpropane-tri-β-aziridinyl propionate, N,N'-diphenylmethane-4,4'-bis(1-aziridinecarboxyamide), and N,N'-hexamethylene-1,6-bis(1-aziridinecarboxyamide) ; isocyanate-based compounds such as tetramethylene diisocyanate, hexamethylene diisocyanate, and polyisocyanate, and the like. From the viewpoint of improving the balance with the heat resistance and adhesion of the adhesive resin layer 30, the content of the cross-linking agent is preferably 0.1 part by mass or more and 10 parts by mass or less with respect to 100 parts by mass of the (meth)acrylic-based adhesive resin.

The thickness of the adhesive resin layer 30 is not particularly limited, but, for example, is preferably 1 pm or more and 100 pm or less, more preferably 3 pm or more and 50 pm or less, and even more preferably 5 um or more and 40 um or less.

It is possible to form the adhesive resin layer 30, for example, by coating an adhesive coating solution on the intermediate layer 20.

As a method for coating the adhesive coating solution, it is possible to adopt a coating method known in the related art, for example, a roll coater method, a reverse roll coater method, a gravure roll method, a bar coating method, a comma coater method, a die coater method, or the like. The drying conditions of the coated adhesive are not particularly limited, but in general, it is preferable to perform the drying in a temperature range of 80°C to 200°C for 10 seconds to 10 minutes. More preferably, drying is performed at 80°C to 170°C for 15 seconds to 5 minutes . In order to sufficiently promote a cross-linking reaction between the cross-linking agent and the adhesive, after the drying of the adhesive coating solution is completed, heating may be carried out at 40 to 80°C for approximately 5 to 300 hours.

### <Other Layers>

In the adhesive film 50 according to the present embodiment, a release film may be further laminated on the adhesive resin layer 30. Examples of the release film include a polyester film subjected to a release treatment.

Specific examples of the configuration of the adhesive film 50 according to the present embodiment include an adhesive film having a layer configuration of 25 um of a biaxially oriented polyethylene naphthalate film/120 um of an ethylene vinyl acetate copolymer film (19% by mass of vinyl acetate unit content)/30 um of an ultraviolet cross-linking adhesive resin layer, an adhesive film having a layer configuration of 50 um of a biaxially oriented polyethylene terephthalate film/70 um of an ethylene vinyl acetate copolymer film (19% by mass vinyl acetate unit content)/30 um of an ultraviolet cross-linking adhesive resin layer, and the like.

### <Method for Manufacturing Adhesive Film>

Next, a description will be given of an example of a method for manufacturing the adhesive film 50 according to the present embodiment.

It is possible to obtain the adhesive film 50 according to the present embodiment, for example, by forming the intermediate layer 20 on one surface of the base material layer 10 by an extrusion lamination method and forming the adhesive resin layer 30 by coating and drying an adhesive coating solution on the intermediate layer 20.

In addition, the base material layer 10 and the intermediate layer 20 may be formed by co-extrusion molding, or the film-like base material layer 10 and the film-like intermediate layer 20 maybe formed by lamination.

### 2. Method for Manufacturing Electronic Device

Next, a description will be given of the method for manufacturing an electronic device according to the present embodiment. Fig. 2 and Fig. 3 are cross-sectional views schematically showing an example of a method for manufacturing an electronic device of an embodiment according to the present invention.

The method for manufacturing an electronic device according to the present embodiment is provided with at least the following two steps.
(A) a step of preparing a structure 100 having the electronic component 70 and the adhesive film 50 attached to the electronic component 70
(B) a step of dicing the electronic component 70 with a dicing blade while in a state of being attached to the adhesive film 50

In the method for manufacturing an electronic device according to the present embodiment, as the adhesive film 50, an adhesive film is used which is provided with the base material layer 10, the intermediate layer 20, and the adhesive resin layer 30 in this order and which, when the thickness of the base material layer 10 is X₁ and the thickness of the intermediate layer 20 is X₂, satisfies the relationship X₂ > X₁.

A description will be given below of each step of the method for manufacturing an electronic device according to the present embodiment.

### (Step (A))

First, the structure 100, which is provided with the electronic component 70 and the adhesive film 50 attached to the electronic component 70, is prepared.

It is possible to obtain such a structure, for example, by attaching the electronic component 70 on the adhesive resin layer 30 of the adhesive film 50.

Examples of the electronic component 70 to be attached to the adhesive film 50 include a semiconductor substrate (for example, a wafer) of silicon, germanium, gallium-arsenide, gallium-phosphorus, gallium-arsenide aluminum, or the like; package substrates in which a plurality of semiconductor chips are in a state of being collectively sealed with a sealing resin such as a mold array package substrate, a fan-out package substrate, and a wafer-level package substrate, and the like.

In addition, as a semiconductor substrate, it is preferable to use a semiconductor substrate with a circuit formed on the surface.

The attachment of the adhesive film 50 may be performed by hand, but is usually performed by an automatic attachment machine to which a roll-shaped surface protection film is attached.

The temperature of the adhesive film 50 and the electronic components 70 at the time of attachment is not particularly limited, but 25°C to 80°C is preferable.

In addition, the pressure between the adhesive film 50 and the electronic component 70 at the time of attachment is not particularly limited, but 0.3 MPa to 0.5 MPa is preferable.

### (Step (B))

Next, a plurality of electronic components 70 are obtained by dicing the electronic components 70 with a dicing blade while in a state of being attached to the adhesive film 50.

Herein, "dicing" refers to the operation of breaking up the electronic components 70 and obtaining a plurality of broken up electronic components 70.

It is possible to perform the dicing described above, for example, using a dicing blade with a tip with a tapered shape.

The electronic components 70 in step (B) include the plurality of broken up electronic components 70 obtained by dicing.

### (Step (C))

In the method for manufacturing an electronic device according to the present embodiment, after step (B), step (C) of evaluating the characteristics of the diced electronic components 70 while in a state of being attached to the adhesive film 50 in a temperature environment of 0°C or lower and 50°C or higher may be further performed.

It is possible to perform the characteristic evaluation of the electronic components 70, for example, an operation confirmation test of the electronic components 70, using a probe card 92 having probe terminals 95, as shown in Fig. 3(c).

For example, the probe terminals 95 connected to the tester through the probe card 92 are brought into contact with terminals 75 of the electronic components 70. Due to this, it is possible to transfer operating power, operating test signals, or the like between the electronic components 70 and the tester and to determine whether the operating characteristics of the electronic components 70 are good or bad or the like.

The environmental temperature in step (C) is 0°C or lower and 50°C or higher, but the lower limit value is preferably 60°C or higher, more preferably 80°C or higher, and even more preferably 85°C or higher, and the upper limit value is preferably 200°C or lower, more preferably 180°C or lower, and even more preferably 160°C or lower. In this manner, it is possible to accelerate the deterioration of the electronic components 70, in which factors which cause defects to occur are inherent, to generate the initial defects of the electronic components 70 at an early stage and to remove these defective products . This makes it possible to obtain the electronic components 70 with excellent reliability at a high yield.

For example, it is possible to set the temperature environment described above by adding the structure 100 to a thermostatic bath or oven, or by carrying out heating with a heater provided in a sample stand 90.

### (Step (D))

In the manufacturing method of an electronic device according to the present embodiment, after step (B) or step (C), a step (D) of picking up the diced electronic components 70 from the adhesive film 50 may be further performed.

Through this picking up, it is possible to peel off the electronic components 70 from the adhesive film 50. It is possible to perform the picking up of the electronic components 70 by a known method.

### (Step (E))

In the method for manufacturing an electronic device according to the present embodiment, before step (D), step (E) may be further performed in which the adhesive film 50 is irradiated with radiation and the adhesive resin layer 30 is cross-linked, thereby decreasing the adhesive strength of the adhesive resin layer 30 with respect to the electronic components 70.

By performing step (E), it is possible to easily pick up the electronic components 70 from the adhesive resin layer 30. In addition, it is possible to suppress contamination of the surface of the electronic component 70 by the adhesive component forming the adhesive resin layer 30.

Radiation is irradiated, for example, from the surface of the adhesive film 50 on the opposite side to the surface of the adhesive resin layer 30 side.

In a case where ultraviolet rays are used as the radiation, the dose of the ultraviolet rays irradiated to the adhesive film 50 is preferably 100 mJ/cm² or more, and more preferably 350 mJ/cm² or more.

When the dose of ultraviolet rays is the lower limit value described above or more, it is possible to sufficiently decrease the adhesive strength of the adhesive resin layer 30 and, as a result, it is possible to further suppress the occurrence of glue residue on the surface of the electronic component 70.

In addition, the upper limit of the dose of ultraviolet rays irradiated to the adhesive film 50 is not particularly limited, but from the viewpoint of productivity, is, for example, 1500 mJ/cm² or less, and preferably 1200 mJ/cm² or less.

For example, it is possible to perform the ultraviolet irradiation using a high-pressure mercury lamp or an LED.

### (Other Steps)

The method for manufacturing an electronic device according to the present embodiment may have other steps other than the steps described above. As other steps, it is possible to use known steps in methods for manufacturing electronic devices.

For example, after performing step (D), any step generally performed in the manufacturing steps of an electronic device may be further performed, such as a step of mounting the obtained electronic component 70 on a circuit substrate, a wire bonding step, a sealing step, and the like.

A description was given above of the embodiments of the present invention, but these are examples of the present invention and it is also possible to adopt various configurations other than the above.

Here, the present invention is not limited to the embodiments described above, but is limited only to the scope as defined by the appended claims.

### REFERENCE SIGNS LIST

- 10:: Base material layer
- 20:: Intermediate layer
- 30:: adhesive resin layer
- 50:: adhesive film
- 50An: adhesive film
- 60:: Dicing blade
- 70:: Electronic component
- 70A:: Electronic component
- 75:: Terminal
- 90:: Sample stand
- 92:: Probe card
- 95:: Probe terminal
- 100:: Structure

## Claims

1. A method for manufacturing an electronic device, the method comprising:
a step (A) of preparing a structure provided with an electronic component and an adhesive film attached to the electronic component; and
a step (B) of dicing the electronic component with a dicing blade in a state of being attached to the adhesive film,
wherein the adhesive film is provided with a base material layer, an intermediate layer, and an adhesive resin layer in this order, and
when a thickness of the base material layer is X₁ and a thickness of the intermediate layer is X₂, a relationship of X₂ > X₁ is satisfied,
wherein a tip of the dicing blade has a tapered shape, and
wherein, when a tip diameter of the dicing blade is R, a relationship of X₂ > R is satisfied.

2. The method for manufacturing an electronic device according to claim 1,
wherein the thickness (X₁) of the base material layer is 1 um or more and 100 um or less, and
the thickness (X₂) of the intermediate layer is 10 pm or more and 500 um or less.

3. The method for manufacturing an electronic device according to claim 1 or 2,
wherein a storage modulus E' of the base material layer at 85°C is 50 MPa or more and 10 GPa or less, and a storage modulus E' of the intermediate layer at 85°C is 1 MPa or more and less than 50 MPa.

4. The method for manufacturing an electronic device according to any one of claims 1 to 3,
wherein the intermediate layer includes a thermoplastic resin.

5. The method for manufacturing an electronic device according to claim 4,
wherein the thermoplastic resin includes one or two or more resins selected from the group consisting of an ethylene-α-olefin copolymer and an ethylene vinyl ester copolymer.

6. The method for manufacturing an electronic device according to claim 5,
wherein the ethylene vinyl ester copolymer includes an ethylene vinyl acetate copolymer.

7. The method for manufacturing an electronic device according to any one of claims 1 to 6, further comprising:
a step (C) of evaluating characteristics of the diced electronic components in a state of being attached to the adhesive film in a temperature environment of 0°C or less and 50°C or more, after the step (B).

8. The method for manufacturing an electronic device according to any one of claims 1 to 7, further comprising:
a step (D) of picking up the diced electronic components from the adhesive film, after the step (B).

## Patentansprüche

1. Verfahren zur Herstellung einer elektronischen Vorrichtung, wobei das Verfahren umfasst:
einen Schritt (A), bei dem eine Struktur vorbereitet wird, die mit einer elektronischen Komponente und einem an der elektronischen Komponente angebrachten Klebefilm versehen ist; und
einen Schritt (B), bei dem die elektronische Komponente mit einem Dicing Blade in einem Zustand einem Dicing unterzogen wird, in dem sie an dem Klebefilm angebracht ist,
wobei der Klebefilm mit einer Basismaterialschicht, einer Zwischenschicht und einer Klebeharzschicht in dieser Reihenfolge versehen ist, und
wenn eine Dicke der Basismaterialschicht X₁ und eine Dicke der Zwischenschicht X₂ ist, die Beziehung X₂ > X₁ erfüllt ist,
wobei eine Spitze des Dicing Blades eine konische Form aufweist, und
wobei, wenn ein Spitzendurchmesser des Dicing Blades R ist, die Beziehung X₂ > R erfüllt ist.

2. Verfahren zur Herstellung einer elektronischen Vorrichtung gemäß Anspruch 1,
wobei die Dicke (X₁) der Basismaterialschicht 1 um oder mehr und 100 um oder weniger beträgt, und
die Dicke (X₂) der Zwischenschicht 10 um oder mehr und 500 um oder weniger beträgt.

3. Verfahren zur Herstellung einer elektronischen Vorrichtung gemäß Anspruch 1 oder 2,
wobei ein Speichermodul E' der Basismaterialschicht bei 85°C 50 MPa oder mehr und 10 GPa oder weniger beträgt, und ein Speichermodul E' der Zwischenschicht bei 85°C 1 MPa oder mehr und weniger als 50 MPa beträgt.

4. Verfahren zur Herstellung einer elektronischen Vorrichtung gemäß mindestens einem der Ansprüche 1 bis 3, wobei die Zwischenschicht ein thermoplastisches Harz enthält.

5. Verfahren zur Herstellung einer elektronischen Vorrichtung gemäß Anspruch 4,
wobei das thermoplastische Harz ein oder zwei oder mehr Harze umfasst, die ausgewählt sind aus einer Gruppe bestehend aus einem Ethylen-α-Olefin-Copolymer und einem Ethylen-Vinylester-Copolymer.

6. Verfahren zur Herstellung einer elektronischen Vorrichtung gemäß Anspruch 5,
wobei das Ethylen-Vinylester-Copolymer ein EthylenVinylacetat-Copolymer umfasst.

7. Verfahren zur Herstellung einer elektronischen Vorrichtung gemäß mindestens einem der Ansprüche 1 bis 6, ferner umfassend:
einen Schritt (C), bei dem die Eigenschaften der elektronischen Komponenten, die dem Dicing unterzogen wurden, nach dem Schritt (B) in einem Zustand ausgewertet werden, in dem sie an dem Klebefilm in einer Temperaturumgebung von 0°C oder weniger und 50°C oder mehr angebracht sind.

8. Verfahren zur Herstellung einer elektronischen Vorrichtung gemäß mindestens einem der Ansprüche 1 bis 7, ferner umfassend:
einen Schritt (D), bei dem die elektronischen Komponenten, die dem Dicing unterzogen wurden, nach dem Schritt (B) von dem Klebefilm genommen werden.

## Revendications

1. Procédé de fabrication d'un dispositif électronique, le procédé comprenant :
une étape (A) consistant à préparer une structure dotée d'un composant électronique et d'un film adhésif fixé au composant électronique ; et
une étape (B) consistant à découper en dés le composant électronique avec une lame de découpage en dés dans un état où il est fixé au film adhésif,
dans lequel le film adhésif est doté d'une couche de matériau de base, d'une couche intermédiaire, et d'une couche de résine adhésive dans cet ordre, et
lorsqu'une épaisseur de la couche de matériau de base est Xi et une épaisseur de la couche intermédiaire est X₂, une relation de X₂ > X₁ est satisfaite,
dans lequel une pointe de la lame de découpage en dés présente une forme effilée, et
dans lequel, lorsqu'un diamètre de pointe de la lame de découpage en dés est R, une relation de X₂ > R est satisfaite.

2. Procédé de fabrication d'un dispositif électronique selon la revendication 1,
dans lequel l'épaisseur (X₁) de la couche de matériau de base est de 1 µm ou plus et de 100 µm ou moins, et
l'épaisseur (X₂) de la couche intermédiaire est de 10 µm ou plus et de 500 µm ou moins.

3. Procédé de fabrication d'un dispositif électronique selon la revendication 1 ou 2,
dans lequel un module de conservation E' de la couche de matériau de base à 85 °C est de 50 MPa ou plus et de 10 GPa ou moins, et un module de conservation E' de la couche intermédiaire à 85 °C est de 1 MPa ou plus et de moins de 50 MPa.

4. Procédé de fabrication d'un dispositif électronique selon l'une quelconque des revendications 1 à 3,
dans lequel la couche intermédiaire inclut une résine thermoplastique.

5. Procédé de fabrication d'un dispositif électronique selon la revendication 4,
dans lequel la résine thermoplastique inclut une ou deux résines ou plus sélectionnées dans le groupe consistant en un copolymère d'éthylène-α-oléfine et un copolymère d'éthylène-ester vinylique.

6. Procédé de fabrication d'un dispositif électronique selon la revendication 5,
dans lequel le copolymère d'éthylène-ester vinylique inclut un copolymère d'éthylène-acétate de vinyle.

7. Procédé de fabrication d'un dispositif électronique selon l'une quelconque des revendications 1 à 6, comprenant en outre :
une étape (C) consistant à évaluer des caractéristiques des composants électroniques découpés en dés dans un état où ils sont fixés au film adhésif dans un environnement de température de 0 °C ou moins et de 50 °C ou plus, après l'étape (B).

8. Procédé de fabrication d'un dispositif électronique selon l'une quelconque des revendications 1 à 7, comprenant en outre :
une étape (D) consistant à prélever les composants électroniques découpés en dés à partir du film adhésif, après l'étape (B).
